# FASCICULE DE BREVET EUROPEEN

(11) **EP 4 518 123 B1**
(45) Date de publication et mention de la délivrance du brevet: **22.07.2026**
(21) Numéro de dépôt: 24198308.9
(22) Date de dépôt: 03.09.2024
(51) Int. Cl.: H02M 1/44, H03H 1/00, H05K 7/14, H01F 17/06

(54) **FILTRE DE COMPATIBILITÉ ÉLECTROMAGNÉTIQUE, CONVERTISSEUR ÉLECTRIQUE CONTINU-CONTINU COMPORTANT UN TEL FILTRE, ENGIN DE MOBILITÉ COMPORTANT UN TEL CONVERTISSEUR OU UN TEL FILTRE, ET PROCÉDÉ DE FABRICATION D'UN TEL FILTRE**
FILTER FÜR ELEKTROMAGNETISCHE KOMPATIBILITÄT, ELEKTRISCHER GLEICHSPANNUNGSWANDLER MIT EINEM SOLCHEN FILTER, MOBILITÄTSMASCHINE MIT EINEM SOLCHEN WANDLER ODER EINEM SOLCHEN FILTER UND VERFAHREN ZUR HERSTELLUNG EINES SOLCHEN FILTERS
ELECTROMAGNETIC COMPATIBILITY FILTER, DC-DC ELECTRICAL CONVERTER COMPRISING SUCH A FILTER, MOBILITY DEVICE COMPRISING SUCH A CONVERTER OR SUCH A FILTER, AND METHOD FOR MANUFACTURING SUCH A FILTER

(30) Priorité: 04.09.2023 FR 2309273
(43) Date de publication de la demande: 05.03.2025
(73) Titulaire: Valeo Electrification, 95892 Cergy Pontoise (FR)
(72) Inventeur: CRAVO, David, 95892 Cergy Pontoise (FR); GILET, Olivier, 95892 Cergy Pontoise (FR)
(74) Mandataire: Valeo Powertrain Systems

(56) Documents cités:
- WO-A1-2019/002710
- US-A1- 2013 279 114
- US-B2- 9 159 506

## Description

### Domaine technique de l'invention

La présente invention concerne un filtre de compatibilité électromagnétique, un convertisseur électrique continu-continu comportant un tel filtre, un engin de mobilité comportant un tel convertisseur ou un tel filtre et un procédé de fabrication d'un tel filtre.

Un engin de mobilité est par exemple un véhicule terrestre à moteur, un train, un aéronef ou bien un drone. Un véhicule terrestre à moteur est par exemple un véhicule automobile, une moto, un vélo motorisé ou bien un fauteuil roulant motorisé.

### Arrière-plan technologique

On connait de l'état de la technique un filtre de compatibilité électromagnétique, comportant :
- un premier conducteur ;
- un deuxième conducteur comportant une pince se projetant selon un axe dit vertical dans un sens dit vers le haut ;
- un troisième conducteur comportant :
   - une première pince et une deuxième pince se projetant sur un même axe dit oblique mais dans des sens opposés, les première et deuxième pinces étant situées plus hautes que la pince du premier conducteur ,
   - une borne de connexion située plus bas que les première et deuxième pinces, et
   - un corps allongé reliant la borne de connexion aux première et deuxième pinces ;
- une première capacité connectée entre le premier conducteur et le troisième conducteur, la première capacité comportant une broche se projetant selon un premier axe sensiblement perpendiculaire à l'axe vertical et à l'axe oblique, cette broche de la première capacité étant enserrée par la première pince du troisième conducteur ;
- une deuxième capacité connectée entre le deuxième conducteur et le troisième conducteur, la deuxième capacité comportant une broche se projetant dans un deuxième axe sensiblement parallèle au premier axe, cette broche de la deuxième capacité étant enserrée par la deuxième pince du troisième conducteur ; et
- une troisième capacité connectée entre le premier conducteur et le deuxième conducteur, la troisième capacité comportant une broche se projetant selon un troisième axe, sensiblement parallèle aux première et deuxième axes, la broche de la troisième capacité étant enserrée par la pince du premier conducteur, la borne de connexion du troisième conducteur étant située plus bas, par rapport à l'axe vertical, que cette broche de la troisième capacité.

Lors de la fabrication du filtre, la pince du premier conducteur est refermée sur sa broche associée par un outil, en particulier une pince de fixation présentant deux éléments conçus pour être placés respectivement de chaque côté de cette pince. La pince peut être une pince d'enserrage, auquel cas les éléments sont conçus pour se rapprocher l'un de l'autre pour pousser mécaniquement respectivement les deux branches de la pince pour qu'elles enserrent la broche associée. La pince peut alternativement ou bien en complément être une pince de soudure, auquel cas les éléments forment des électrodes pour faire passer un courant au travers de la pince à fermer et de la broche associée pour les souder l'un à l'autre.

Ainsi, pour laisser suffisamment de place à ces éléments, le corps allongé du troisième conducteur doit passer à distance de la pince, ce qui augmente l'encombrement global du filtre.

Le document WO 2019/002710 divulgue un convertisseur de tension comportant un module principal comportant une barre omnibus positive principale, une barre omnibus négative principale, au moins une barre omnibus de phase, ainsi qu'un module bornier comportant en outre un tore magnétique entourant des barres omnibus auxiliaires. Le module bornier comporte en outre une première paire de condensateurs de filtrage en montage de type Y, c'est-à-dire destinés à être respectivement connectés entre les barres omnibus positive et négative et une masse électrique. Le module bornier comporte en outre un condensateur de filtrage en montage de type X, c'est-à-dire destiné à être connecté entre les deux barres omnibus positive et négative.

Le document US 2013/279114 divulgue un module semi-conducteur de puissance comportant une unité de circuit de condensateurs avec trois condensateurs.

II peut ainsi être souhaité de prévoir un filtre de compatibilité électromagnétique réalisable par l'outil classique et dont l'encombrement est réduit.

### Résumé de l'invention

II est donc proposé un filtre de compatibilité électromagnétique, comportant :
- un premier conducteur ;
- un deuxième conducteur comportant une pince se projetant selon un axe dit vertical dans un sens dit vers le haut ;
- un troisième conducteur comportant :
   - une première pince et une deuxième pince se projetant sur un même axe dit oblique mais dans des sens opposés, les première et deuxième pinces étant situées plus hautes que la pince du premier conducteur ,
   - une borne de connexion située plus bas que les première et deuxième pinces, et
   - un corps allongé reliant la borne de connexion aux première et deuxième pinces ;
- une première capacité connectée entre le premier conducteur et le troisième conducteur, la première capacité comportant une broche se projetant selon un premier axe sensiblement perpendiculaire à l'axe vertical et à l'axe oblique, cette broche de la première capacité étant enserrée par la première pince du troisième conducteur ;
- une deuxième capacité connectée entre le deuxième conducteur et le troisième conducteur, la deuxième capacité comportant une broche se projetant dans un deuxième axe sensiblement parallèle au premier axe, cette broche de la deuxième capacité étant enserrée par la deuxième pince du troisième conducteur ; et
- une troisième capacité connectée entre le premier conducteur et le deuxième conducteur, la troisième capacité comportant une broche se projetant selon un troisième axe, sensiblement parallèle aux première et deuxième axes, la broche de la troisième capacité étant enserrée par la pince du premier conducteur, la borne de connexion du troisième conducteur étant située plus bas, par rapport à l'axe vertical, que cette broche de la troisième capacité ;
caractérisé en ce que la broche de la première capacité est située plus haut, par rapport à l'axe vertical, que la broche de la deuxième capacité, de sorte que l'axe oblique et l'axe vertical fassent entre eux un angle inférieur à 80°, de préférence inférieur à 70°, par exemple de 65°.

Ainsi, grâce à l'invention, le corps allongé peut partir en biais au niveau des première et deuxième pinces, et donc s'écarter de la pince du troisième conducteur pour passer à distance suffisante de cette dernière, tout en gardant la deuxième capacité proche de la troisième capacité.

L'invention peut en outre comporter l'une ou plusieurs des caractéristiques optionnelles suivantes, selon toute combinaison techniquement possible.

De façon optionnelle, la première pince du troisième conducteur est plus haute que la deuxième pince du troisième conducteur.

De façon optionnelle également, les capacités présentent des boîtiers respectifs de forme générale parallélépipédiques avec des faces supérieures perpendiculaires à l'axe vertical, la face supérieure de la première capacité s'étendant plus haut que la face supérieure de la deuxième capacité et la face supérieure de la troisième capacité s'étendant au-dessous de la face supérieure de la deuxième capacité.

De façon optionnelle également, la première capacité présente une autre broche parallèle à la première broche, la deuxième capacité présente une autre broche parallèle à la première broche, un premier plan défini par les deux broches de la première capacité et un deuxième plan défini par les deux broches de la deuxième capacité étant sensiblement parallèles, le premier plan s'étendant au-dessus du deuxième plan.

De façon optionnelle également, le corps allongé présente une portion d'extrémité droite à partir de laquelle les pinces du troisième conducteur se projettent sensiblement perpendiculairement, cette portion d'extrémité droite s'écartant horizontalement de la pince du premier conducteur en suivant cette portion d'extrémité droite depuis les pinces du troisième conducteur.

Il est également proposé un procédé de fabrication d'un filtre de comptabilité électromagnétique selon l'invention, comportant :
- une obtention d'un filtre de compatibilité électromagnétique, comportant :
   - un premier conducteur,
   - un deuxième conducteur comportant une pince se projetant selon un axe dit vertical dans un sens dit vers le haut,
   - un troisième conducteur comportant : une première pince et une deuxième pince se projetant sur un même axe dit oblique mais dans des sens opposés, les première et deuxième pinces étant situées plus hautes que la pince du premier conducteur, une borne de connexion située plus bas que les première et deuxième pinces, et un corps allongé reliant la borne de connexion aux première et deuxième pinces,
   - une première capacité connectée entre le premier conducteur et le troisième conducteur, la première capacité comportant une broche se projetant selon un premier axe sensiblement perpendiculaire à l'axe vertical et à l'axe oblique,
   - une deuxième capacité connectée entre le deuxième conducteur et le troisième conducteur, la deuxième capacité comportant une broche se projetant selon un deuxième axe sensiblement parallèle au premier axe,
   - une troisième capacité connectée entre le premier conducteur et le deuxième conducteur, la troisième capacité comportant une broche se projetant selon un troisième axe, parallèle aux premier et deuxième axes, la borne de connexion du troisième conducteur étant située plus bas, par rapport à l'axe vertical, que cette broche de la troisième capacité,
   - la broche de la première capacité étant située plus haut, par rapport à l'axe vertical, que la broche de la deuxième capacité, de sorte que l'axe oblique et l'axe vertical fassent entre eux un angle inférieur à 80°, de préférence inférieur à 70°, par exemple de 65° ; et
- pour la pince du deuxième conducteur, un placement de deux éléments respectivement de chaque côté de la pince, l'un des éléments s'étendant entre la pince et le corps allongé du troisième conducteur et une utilisation des éléments pour que la pince enserre la broche de la troisième capacité ; et
- pour chacune des première et deuxième pinces du troisième conducteur, un placement de deux éléments respectivement de chaque côté de la pince et une utilisation des éléments pour que la pince enserre respectivement la broche de la première capacité et la broche de la deuxième capacité.

De façon optionnelle, l'utilisation des éléments comporte un rapprochement des éléments l'un de l'autre.

De façon optionnelle également, l'utilisation des éléments comporte l'utilisation des éléments comme électrodes pour faire passer un courant au travers de la pince et de la broche associée pour les souder l'un à l'autre.

Il est également proposé un convertisseur électrique continu-continu comportant :
- un circuit électrique de conversion conçu pour convertir une tension d'entrée continue en une tension de sortie continue ;
- un connecteur d'entrée ou bien de sortie, comportant deux broches plates, l'une positive et l'autre négative, conçues pour recevoir la tension d'entrée ou bien pour fournir la tension de sortie ; et
- un filtre de compatibilité électromagnétique selon l'invention, dans lequel les premier et deuxième conducteurs sont respectivement connectées aux deux broches, et dans lequel le troisième connecteur est connecté à une masse électrique.

Il est également proposé un engin de mobilité comportant un filtre de compatibilité électromagnétique selon l'invention ou bien un convertisseur électrique continu-continu selon l'invention.

### Brève description des figures

L'invention sera mieux comprise à l'aide de la description qui va suivre, donnée uniquement à titre d'exemple et faite en se référant aux dessins annexés dans lesquels :
- la figure 1 est une vue simplifiée d'un engin de mobilité dans lequel l'invention peut être mise en œuvre,
- la figure 2 est une vue simplifiée en trois dimensions d'un convertisseur électrique continu-continu de l'engin de mobilité de la figure 1,
- la figure 3 est une vue en trois dimensions d'un connecteur du convertisseur de la figure 2,
- la figure 4 est une vue en trois dimensions du connecteur de la figure 3, selon un angle de vue différent et en l'absence d'un tore magnétique,
- la figure 5 est une vue en trois dimensions d'un filtre de compatibilité électromagnétique associé au connecteur des figures 3 et 4,
- la figure 6 est une vue en trois dimensions du filtre de compatibilité électromagnétique, isolé du connecteur,
- la figure 7 est une vue du compatibilité électromagnétique où sont représentés les emplacements d'éléments d'un outil de fixation de pinces,
- la figure 8 est une vue similaire à celle de la figure 7 sans décalage vertical de deux capacités,
- la figure 9 est une vue en trois dimensions du connecteur des figures 3 et 4 et d'un autre connecteur du convertisseur électrique continu-continu,
- la figure 10 est une vue en trois dimension de l'autre connecteur et d'un filtre de compatibilité électromagnétique associé.
- la figure 11 est une série de vues en trois dimensions illustrant les étapes successives d'un procédé de fabrication de l'autre connecteur représenté sur les figure 9 et 10,

### Description détaillée de l'invention

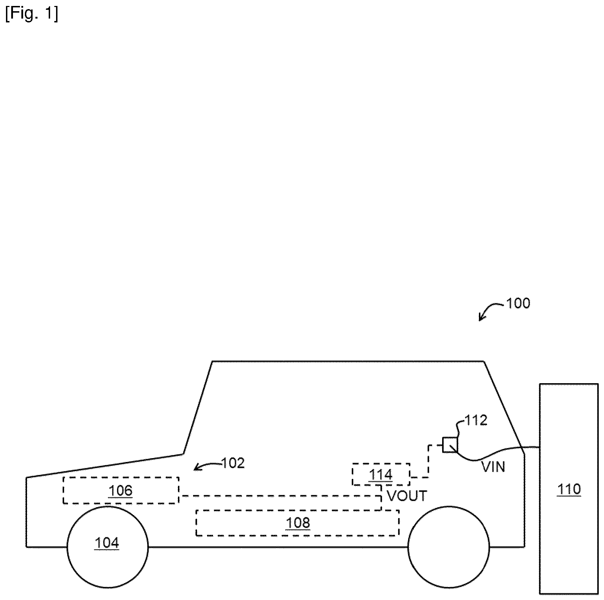

En référence à la figure 1, un engin de mobilité 100 dans lequel l'invention peut être utilisée, va à présent être décrit.

L'engin de mobilité 100 comporte un système de propulsion 102, par exemple des roues motrices 104 et un moteur électrique 106 conçu pour entraîner les roues motrices 104. L'engin de mobilité 100 comporte en outre une batterie 108 conçue pour alimenter électriquement le moteur électrique 106.

Pour recharger la batterie 108 à une station de recharge 110 connectée à un réseau de distribution électrique (non représenté), l'engin de mobilité 100 comporte en outre une prise électrique 112 conçue pour être connectée à la station de recharge 110, ainsi qu'un convertisseur électrique continu-continu 114 connecté entre la prise électrique 112 et la batterie 108, afin de convertir une tension d'entrée VIN reçue de la station de recharge 110 au travers de la prise électrique 112 en une tension de sortie VOUT fournie à la batterie 108.

Dans la suite de la description, la disposition des différents éléments du convertisseur 114 fera référence à un repère arbitraire comportant un axe gauche-droite X, un axe bas-haut Y et un axe avant-arrière Z.

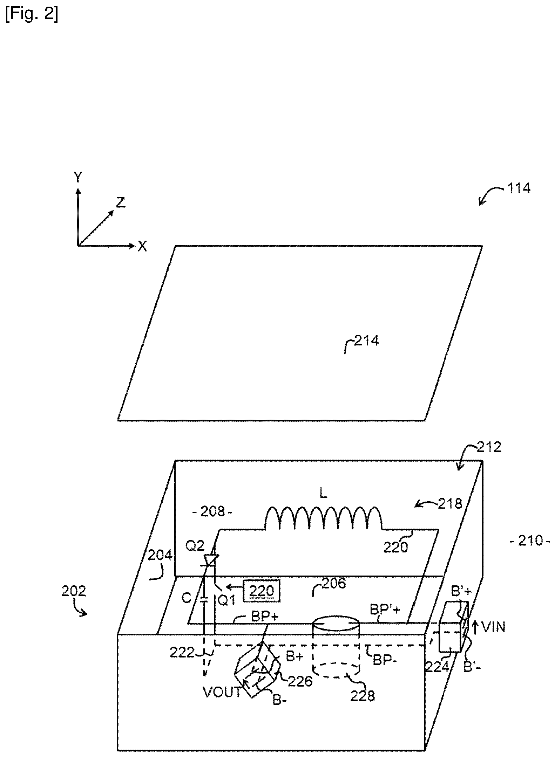

En référence à la figure 2, le convertisseur 114 va à présent être décrit plus en détail.

Le convertisseur 114 comporte tout d'abord un boîtier 202 comportant des parois latérales 204 et un fond 206 définissant ensemble un espace intérieur 208 du boîtier 202 et un espace extérieur 210 au boîtier 202. Les parois latérales 204 peuvent en outre définir, à l'opposé du fond 206, une ouverture supérieure 212. Dans ce cas, le boîtier 202 peut en outre comporter un couvercle 214 conçu pour fermer l'ouverture supérieure 212.

Le convertisseur 114 comporte en outre un circuit électrique de conversion 218 s'étendant dans l'espace intérieur 208 du boîtier 202. Le circuit électrique de conversion 218 est conçu pour convertir la tension d'entrée VIN en la tension de sortie VOUT. Par exemple, le convertisseur 114 peut être un hacheur parallèle (« boost converter » ou bien « step-up converter » en anglais), auquel cas le circuit de conversion 218 comporte par exemple une branche positive 220 et une branche négative 222, présentant un côté d'entrée et un côté de sortie. Le circuit de conversion 218 comporte une inductance L sur la branche positive, ainsi qu'un interrupteur Q1 et une capacité C, en parallèle l'un de l'autre entre la branche positive 220 et la branche négative 222, du côté de sortie par rapport à l'inductance L, et un autre interrupteur Q2 sur la branche positive, entre l'interrupteur Q1 et la capacité C, par exemple une diode passante vers la capacité C (sa cathode du côté de la capacité C). Le convertisseur 114 comporte alors en outre un circuit de commande 220 conçu pour commander l'interrupteur Q pour réaliser la conversion.

Pour recevoir la tension d'entrée VIN, le convertisseur 114 comporte en outre un connecteur d'entrée 224 accessible depuis l'espace extérieur 210 afin d'être connecté à la prise externe 112 par une connexion électrique (non représentée) présentant, à l'une de ses extrémités, un connecteur complémentaire du connecteur d'entrée 224. Le connecteur d'entrée 224 comporte ainsi deux broches d'entrée B'+, B'- : la première broche B'+ est dite positive pour recevoir le potentiel positif de la tension d'entrée VIN et la deuxième broche B'- est dite négative pour recevoir le potentiel négatif de la tension d'entrée VIN.

Pour fournir la tension de sortie VOUT, le convertisseur 114 comporte en outre un connecteur de sortie 226 accessible depuis l'espace extérieur 210 afin d'être connecté à la batterie 108 par une connexion électrique (non représentée) présentant, à l'une de ses extrémités, un connecteur complémentaire du connecteur de sortie 226. Le connecteur de sortie 226 comporte ainsi deux broches de sortie B+, B- : la première broche B+ est dite positive pour fournir le potentiel positif de la tension de sortie VOUT et la deuxième broche B- est dite négative pour fournir le potentiel négatif de la tension de sortie VOUT.

Pour connecter les potentiels négatifs entre eux, le convertisseur 114 comporte une deuxième barre omnibus principale, dite négative, BP- connectant la broche d'entrée négative B'- et la broche de sortie négative B- entre elles, ainsi qu'à la ligne négative 222 du circuit de conversion 218.

Le convertisseur 114 comporte en outre une barre omnibus principale d'entrée positive BP'+ connectant la broche d'entrée positive B'+ au côté d'entrée de la branche positive 220 du circuit de conversion 218, et une première barre omnibus principale, dite de sortie positive, BP+ connectant la broche de sortie positive B+ au côté de sortie de la branche positive 220 du circuit de conversion 218.

Le convertisseur 114 peut en outre comporter un commutateur 228 pour sélectivement connecter et déconnecter les barres omnibus principales positives BP+, BP'+. Cela permet de court-circuiter le circuit de conversion 218 pour que la tension de sortie VOUT soit égale à la tension d'entrée VIN. Cette fonction est utile par exemple lorsque la station de recharge 110 fournit une tension d'entrée VIN qui est déjà à la tension nécessaire pour la recharge de la batterie 108.

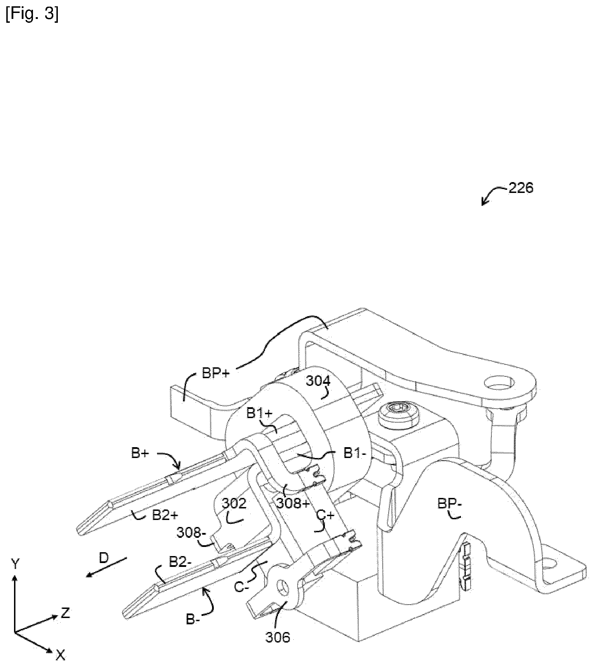

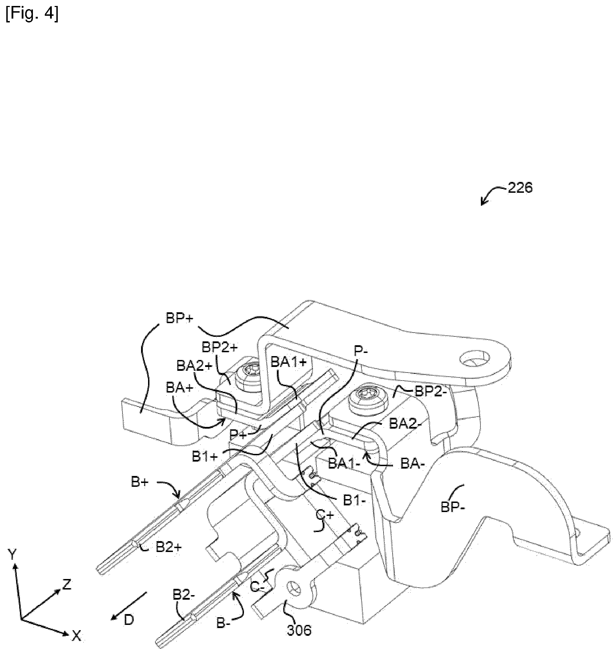

En référence aux figures 3 et 4, le connecteur de sortie 226 va à présent être décrit plus en détail.

En référence à la figure 3, les broches de sortie B+, B- comportent par exemple respectivement deux barres omnibus plates, par exemple avec une épaisseur comprise entre 1 mm et 5 mm, par exemple 4 mm, présentant chacune une portion de fixation plane B1+, B1- et une portion d'extrémité plane B2+, B2-. Les portions d'extrémité B2+, B2- se projettent par exemple vers l'espace extérieur 210 selon un axe D (dans le sens avant dans l'exemple illustré) et sont conçues pour être connectées au connecteur complémentaire du connecteur de sortie 226 selon cet axe D. Dans d'autres modes de réalisation, le portions d'extrémité B2+, B2- pourrait avoir une géométrie autre que plane, par exemple une géométrie de tige à section circulaire se projetant selon l'axe D.

Les portions de fixation planes B1+, B1- s'étendent sensiblement parallèlement, par exemple à 1° près, l'une en face de l'autre, par exemple à moins de 10 mm l'une de l'autre, par exemple à 4 mm l'une de l'autre. De même, les portions d'extrémité planes B2+, B2- s'étendent sensiblement parallèlement, par exemple à 1° près, l'une en face de l'autre, mais à une distance plus grande que les portions de fixation planes B1+, B1-, par exemple au moins deux fois plus grande, par exemple entre 20 mm et 30 mm l'une de l'autre, par exemple à 25,7 mm l'une de l'autre. Par exemple, l'une des broches de sortie B+, B- (par exemple la broche de sortie positive B+, comme dans l'exemple illustré) est plane, tandis que l'autre des broches de sortie B+, B- (par exemple la broche de connexion négative B-, comme dans l'exemple illustré) présente une jonction 302 entre la portion d'extrémité B2- et la portion de fixation B1-, cette jonction 302 présentant deux coudes par exemple réalisés en pliant la broche de connexion B- dans sa largeur.

Le connecteur de sortie 226 comporte en outre un premier filtre de compatibilité électromagnétique. Ce premier filtre comporte par exemple tout d'abord un tore magnétique 304 entourant les broches de sortie B+, B-, et plus précisément les portions de fixation B1+, B1- du fait de leur écartement faible. Le premier filtre comporte en outre par exemple deux capacités C+, C- connectées entre une barre omnibus 306 connectée à une masse électrique (par exemple, le boîtier 202) et respectivement la broche de sortie positive B+ et la broche de sortie négative B-. Par exemple, la broche de sortie positive B+ comporte une patte 308+ s'étendant depuis la barre omnibus plate jusqu'à la capacité C+. De même, la broche de sortie négative B- peut comporter une patte 308- s'étendant depuis la barre omnibus plate jusqu'à la capacité C-. Ces pattes 308+, 308- sont situées entre le tore magnétique 304 et les portions extrémités B2+, B2- des broches de sortie B+, B-.

En référence à la figure 4, le connecteur de sortie 226 comporte en outre deux barres omnibus auxiliaires BA+, BA-. La première BA+ est dite positive et intercalée entre la broche positive B+ et la barre omnibus principale positive BP+. La deuxième BA- est dite négative et intercalée entre la broche négative B- et la barre omnibus négative BP-.

Ainsi, chaque barre omnibus auxiliaire BA+, BA- comporte une première portion plane BA1+, BA1- fixée sur la broche positive B+, respectivement négative B-, et plus précisément sur sa portion de fixation B1+, respectivement B1-. Les portions planes BA1+, BA1- des barres omnibus auxiliaires BA+, BA- sont par exemple plaquées et fixées contre des faces des portions de fixation B1+, B1-. Par exemple, les portions de fixation B1+, B1- présentent des faces en vis-à-vis (se faisant face) et des faces externes, de l'autre côté des faces en vis-à-vis. Ainsi, les portions planes BA1+, BA1- des barres omnibus auxiliaires BA+, BA- sont par exemple plaquées et fixées contre ces faces externes (comme dans l'exemple illustré).

Chaque barre omnibus auxiliaire BA+, BA- comporte en outre une deuxième portion plane BA2+, BA2-. Ces deuxièmes portions planes BA2+, BA2- sont sensiblement parallèles, par exemple à 1° près, l'une à l'autre, par exemple coplanaires. Suivant l'orientation des broches de sortie B+, B- autour de leur axe D, chaque portion BA2+, BA2- peut s'étendre dans la continuité de la première portion plane BA1+, BA1- (auquel cas les barres omnibus auxiliaires BA+, BA- sont planes) ou bien avec un angle non plat (comme dans l'exemple illustré). Dans ce dernier cas, chaque barre omnibus auxiliaire BA+, BA- présente par exemple une pliure P+, P-entre les portions BA1+, BA2+ et BA1-, BA2-, sensiblement parallèle à l'axe D, par exemple à 1° près.

Des portions planes BP2+, BP2- de respectivement les barres omnibus principales BP+, BP- sont plaquées et fixées respectivement contre les deuxièmes portions BA2+, BA2- des barres omnibus auxiliaire BA+, BA-. Du fait que les deuxièmes portions BA2+, BA2- s'étendent parallèlement, leur fixation peut être réalisée de manière similaire, en particulier selon un même axe de fixation, quelle que soit l'orientation des broches de sortie B+, B- autour de l'axe D. En particulier, lorsque cette fixation est faite par vissage (comme dans l'exemple illustré), le vissage peut être réalisé selon l'axe perpendiculaire aux deuxièmes portions BA2+, BA2-, verticalement dans l'exemple illustré. Cet axe de vissage peut également être utilisé pour d'autre vis du convertisseur 114. Ainsi, un même outil peut être utilisé pour réaliser tous ces vissages, quelle que soit l'orientation des broches B+, B- autour de leur axe D.

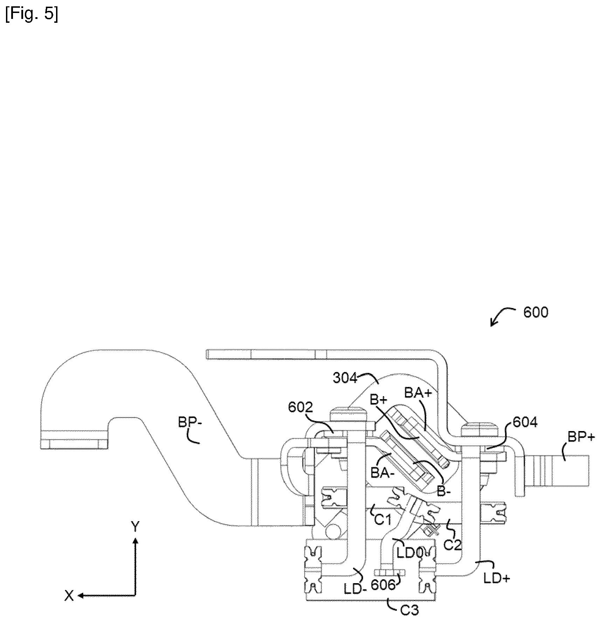

En référence à la figure 5, le convertisseur 114 comporte en outre un deuxième filtre de compatibilité électromagnétique 600 pour le connecteur de sortie 226.

Ce filtre de compatibilité électromagnétique 600 comporte tout d'abord une barre omnibus négative LD- connectée à la barre omnibus principale négative BP-. Pour cela, la barre omnibus négative LD- comporte par exemple une borne de fixation 602 fixée à la barre omnibus principale négative BP-, par exemple par la même vis que la barre omnibus auxiliaire négative BA-. Le filtre de compatibilité électromagnétique 600 comporte en outre une barre omnibus positive LD+ connectée à la barre omnibus de sortie principale positive BP+. Pour cela, la barre omnibus LD+ comporte par exemple une borne de fixation 604 fixée à la barre omnibus de sortie principale positive BP+, par exemple par la même vis que la barre omnibus auxiliaire positive BA+. Le filtre de compatibilité électromagnétique 600 comporte en outre une barre omnibus de masse LD0 connectée à la masse électrique, par exemple au boîtier 202. Pour cela, la barre omnibus de masse LD0 comporte une borne de fixation 606 fixée à la masse électrique.

Le filtre de compatibilité électromagnétique 600 comporte en outre une capacité C1 connectée entre la barre omnibus négative LD- et la barre omnibus de masse LD0, une capacité C2 connectée entre la barre omnibus positive LD+ et la barre omnibus de masse LD0, et une capacité C3 connectée entre la barre omnibus positive LD+ et la barre omnibus négative LD-. Toutes les capacités C1, C2, C3 présentent par exemple des boîtiers respectifs de forme générale parallélépipédique avec des faces supérieures horizontales, parallèles entre elles, perpendiculaires à l'axe Y.

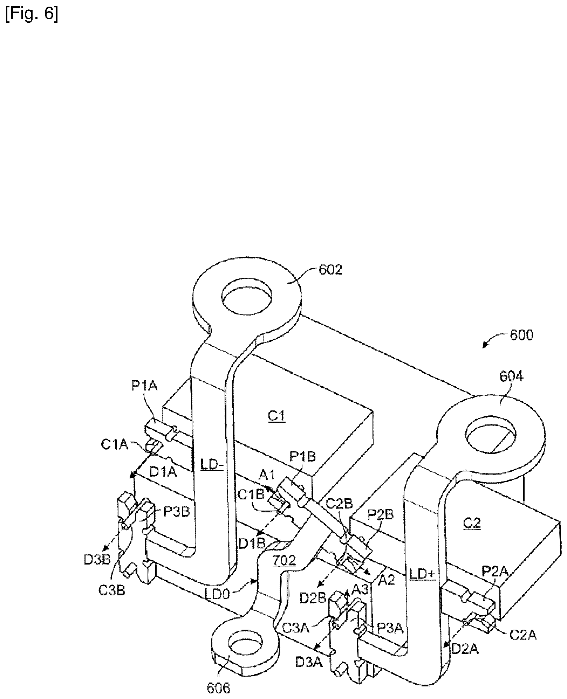

En référence à la figure 6, pour être connectée, la capacité C1 comporte deux broches C1A, C1B se projetant selon des axes D1A, D1B, parallèles à l'axe Z dans l'exemple illustré. Ainsi, la barre omnibus négative LD- comporte une pince P1A enserrant la broche C1A et la barre omnibus de masse LD0 présente une pince P1B enserrant la broche C1B. La pince P1B se projette, c'est-à-dire s'ouvre, selon un axe dit oblique et un sens A1 sur cet axe.

De même, pour être connectée, la capacité C2 comporte deux broches C2A, C2B se projetant selon des axes D2A, D2B. Ainsi, la barre omnibus positive LD+ comporte une pince P2A enserrant la broche C2A et la barre omnibus de masse LD0 présente une pince P2B enserrant la broche C2B. La pince P2B se projette, c'est-à-dire s'ouvre, selon le même axe, par exemple à 1° près, que l'axe de la pince P1B, et dans un sens A2. Les pinces P1B et P2B sont positionnées tête-bêche, c'est-à-dire que les sens A1, A2 sont opposées.

De même, pour être connectée, la capacité C3 comporte deux broches C3A, C3B (pouvant être chacune dédoublée comme dans l'exemple illustré) se projetant selon des sens avant D3A, D3B. Ainsi, la barre omnibus positive LD+ présente une pince P3A enserrant la broche C3A. Cette pince P3A se projette, c'est-à-dire s'ouvre, dans l'axe vertical Y dans le sens A3 vers le haut. La barre omnibus négative LD-présente elle-aussi une pince P3B qui se projette, c'est-à-dire s'ouvre, dans l'axe vertical Y dans le sens A3 vers le haut et enserrant la broche C3B.

Le conducteur de masse LD0 comporte un corps allongé 702 s'étendant depuis les pinces P1B, P2B vers le bas, au moins jusqu'au niveau de la broche C3A. Par exemple, la borne 606 du conducteur de masse LD0 est située plus bas que cette broche C3A, de sorte que le corps allongé 702 passe sur le côté de la broche C3A et entre les broches C3A et C3B.

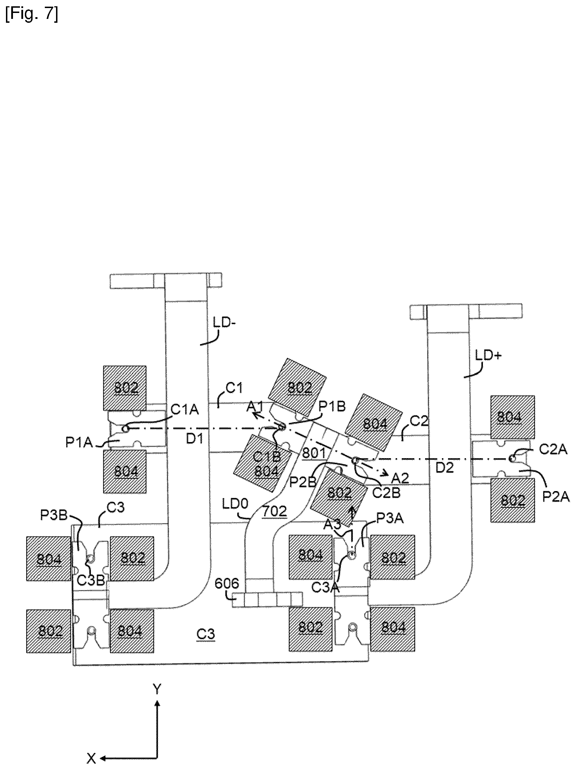

Or, en référence à la figure 7, lors de la fabrication du filtre de compatibilité électromagnétique 600, chaque pince P1A, P1B, P2A, P2B, P3A, P3B est refermée sur sa broche C1A, C1B, C2A, C2B, C3A, C3B associée par un outil, en particulier une pince de fixation présentant deux éléments 802, 804 conçus pour être placés respectivement de chaque côté de la pince P1A, P1B, P2A, P2B, P3A, P3B. La pince de fixation peut être une pince d'enserrage, auquel cas les éléments sont conçus pour se rapprocher l'un de l'autre pour pousser mécaniquement respectivement les deux branches de la pince P1A, P1B, P2A, P2B, P3A, P3B pour qu'elles enserrent la broche associée C1A, C1B, C2A, C2B, C3A, C3B. La pince de fixation peut également être une pince à soudure électrique, auquel cas les éléments 802, 804 forment en outre ou alternativement des électrodes pour faire passer un courant au travers de la pince P1A, P1B, P2A, P2B, P3A, P3B et de la broche C1A, C1B, C2A, C2B, C3A, C3B associée pour les souder l'une à l'autre.

Ainsi, pour laisser suffisamment de place à ces éléments 802, 804, le corps allongé de la barre omnibus de masse LD0 doit passer à distance de la pince P3A.

En outre, afin que le filtre de compatibilité électromagnétique 600 soit le plus compact possible, il est souhaitable que les capacités C1 et C2, qui s'étendent au-dessus de la capacité C3, soient les plus proches possible de cette dernière.

Pour satisfaire ces deux contraintes, la capacité C1 est placée de sorte que sa broche C1B soit située plus haut que la broche C2B de la deuxième capacité C2. Ainsi, les sens opposés A1, A2 et le sens A3 font entre eux un angle inférieur à 80°, de préférence inférieur à 70°, par exemple 65°, ce qui permet au corps allongé 702 de présenter une portion d'extrémité droite 801, de laquelle les pinces P1B, P2B se projettent sensiblement perpendiculairement, par exemple à 1° près, qui est verticalement en biais pour s'éloigner de la pince P3A. Ainsi, il est possible de garder une distance suffisante entre la pince P3A et le corps allongé 702 pour le passage des éléments 802, 804 (en particulier de l'élément 804) de l'outil, tout en gardant la capacité C2 basse, proche de la capacité C3.

Par exemple, la capacité C1 est placée de sorte que sa face supérieure s'étende plus haut que la face supérieure de la capacité C2, c'est-à-dire à une hauteur plus élevée. Par exemple, la hauteur de la face supérieure de la capacité C1 est au moins 5 mm, de préférence au moins 10 mm, plus élevée que la hauteur de de la face supérieure de la capacité C2.

Toujours par exemple, les broches de chaque capacité C1, C2 définissent une ligne droite D1, D2. Ces deux lignes droites D1, D2 sont sensiblement parallèles, par exemple à 1° près, avec la ligne D1 au-dessus de la ligne D2, par exemple au moins 5 mm au-dessus, par exemple entre 5 mm et 10 mm au-dessus.

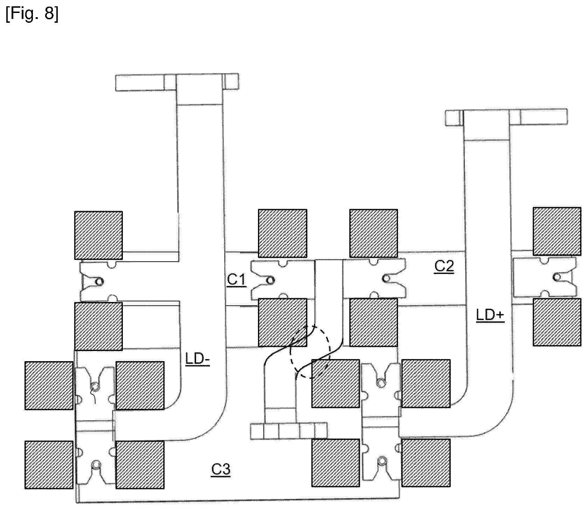

En référence à la figure 8, si la capacité C1 était placée au même niveau que la capacité C2, le corps allongé 702 s'étendrait trop proche de la pince P1B et/ou de la pince P3A pour permettre le passage des éléments 802, 804 de l'outil (voir la zone entourée en pointillés).

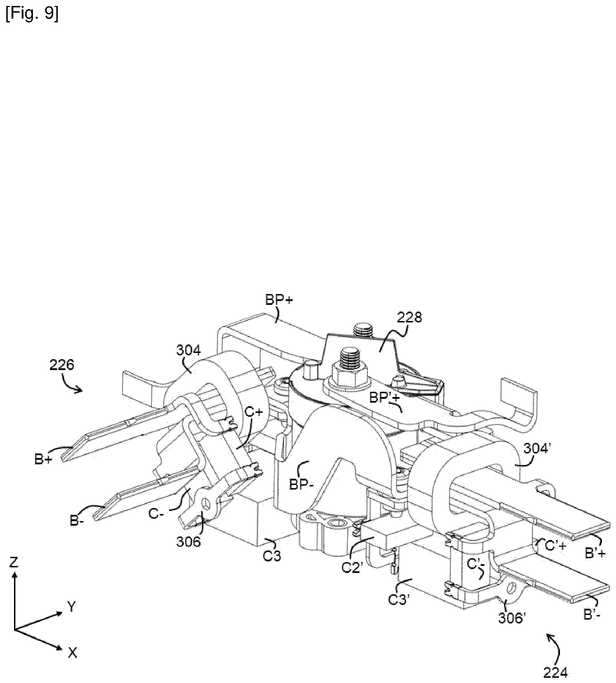

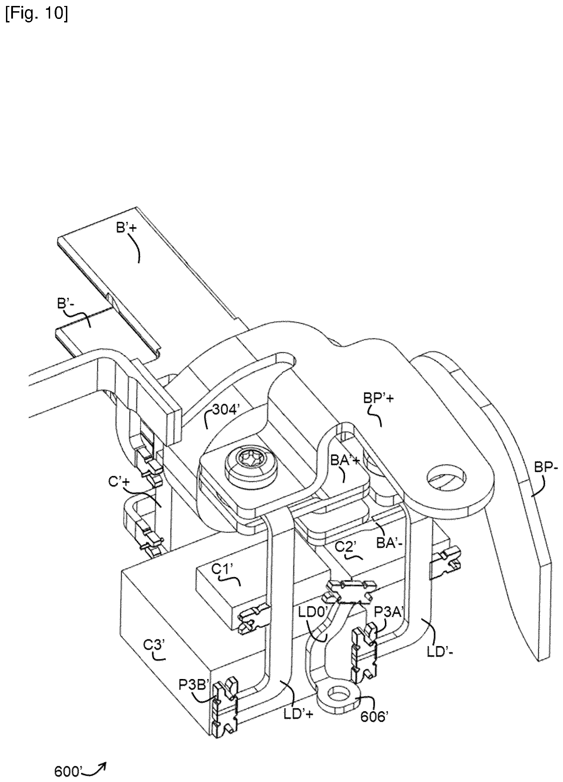

En référence à la figure 9 et 10, le connecteur d'entrée 224 présente des éléments similaires à ceux du connecteur de sortie 226, pour lesquels les références des figures précédentes sont reprises, avec « ' » pour les distinguer. Les broches d'entrée B'+, B'- sont identiques aux broches de sortie B+, B', en particulier de même forme. Les broches d'entrée B'+, B'- s'étendent horizontalement, c'est-à-dire perpendiculairement à la direction de fixation (par exemple de vissage). Ainsi, il n'y a pas d'angle à compenser, de sorte que les barres omnibus auxiliaires BA'+, BA'- sont plates.

En outre, un filtre de compatibilité électromagnétique 600' est également prévu derrière le connecteur d'entrée 224 et présente des éléments similaires à ceux du filtre de compatibilité électromagnétique 600, pour lesquels les références des figures précédentes sont reprises, avec « ' » pour les distinguer. En particulier, comme précédemment, les capacités C1', C2' sont décalées verticalement afin de faciliter le passage de la barre omnibus LD0' à distance de la pince

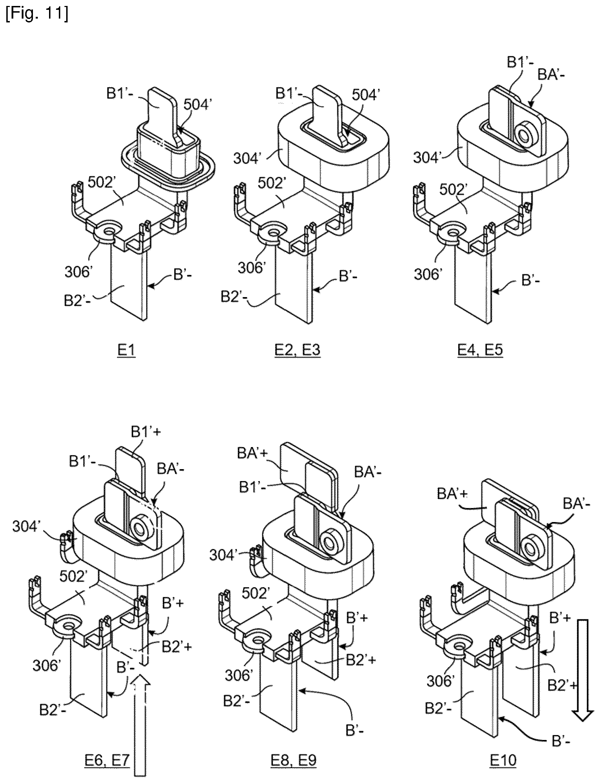

En référence à la figure 11, un exemple de procédé de fabrication du connecteur d'entrée 224 est décrit.

Le connecteur de sortie 226 est obtenu par un procédé identique.

Au cours d'une étape E1, on obtient la broche négative B'- et, par exemple, la barre omnibus 306'. Les deux sont par exemple obtenues surmoulées par un surmoulage 502', laissant apparent les portions B1'-, B2'- de la broche négative B'-. Le surmoulage 502' présente en outre une ouverture traversante 504' dans une partie du surmoulage 502' surmoulant la portion B1'- de la broche négative B'-. Dans d'autres exemples de réalisation, le surmoulage 502' pourrait être dépourvu d'ouverture traversante 504'.

Au cours d'une étape E2, on obtient le tore magnétique 304'.

Au cours d'une étape E3, la broche négative B'- est insérée, par sa portion de fixation B1'-, dans le tore magnétique 304', par exemple jusqu'à ce que le tore 304' s'étende autour du surmoulage 502', par exemple autour de la partie du surmoulage 302' présentant l'ouverture traversante 504'.

Au cours d'une étape E4, on obtient la barre omnibus auxiliaire négative BA'-.

Au cours d'une étape E5, la portion BA1'- de la barre omnibus auxiliaire négative BA'- est plaquée et fixée contre la portion de fixation B1'- de la broche négative B'-. La fixation est par exemple réalisée par soudage, par exemple par brasure électrique et/ou par dépôt d'un maillon d'argent entre les deux portions BA1'-, B1'- à fixer.

Au cours d'une étape E6, on obtient la branche positive B'+ comprenant les portions B1'+, B2'+.

Au cours d'une étape E7, la broche positive B'+ est insérée, par sa portion de fixation B1'+, dans le tore 304', en décalant, par exemple vers le haut comme dans l'exemple illustré, sa portion de fixation B1'+ de la portion de fixation B1'- de la broche négative B'-. En particulier, comme dans l'exemple illustré, la broche positive B'+ est insérée dans l'ouverture traversante 504' du surmoulage 502', de sorte que le tore 304' entoure la portion de fixation B1'+ de la broche positive B'+.

Au cours d'une étape E8, on obtient la barre omnibus auxiliaire positive BA'+.

Au cours d'une étape E9, la portion BA1'+ de la barre omnibus auxiliaire positive BA'+ est plaquée et fixée contre la portion de fixation B1'+ de la broche positive B'+. Cette fixation est facilitée par le décalage entre les portions de fixation B1'+, B1'- des broches B'-, B'+, qui permet un accès par les deux côtés. La fixation est par exemple réalisée par soudage.

Au cours d'une étape E10, la broche positive B'+ est glissée vers le bas dans le tore 304' pour placer les portions de fixation B1'+, B1'- en vis-à-vis l'une de l'autre. Par exemple, comme dans l'exemple illustré, la broche positive B'+ est glissée vers le bas dans l'ouverture traversante 504' du surmoulage 502'.

Une fois le connecteur 226 obtenu par le procédé de fabrication d'un connecteur tel que décrit précédemment, ce connecteur est assemblé aux deux barres omnibus principales positive BP+ et négative BP- du convertisseur de tension continu-continu 114 selon un procédé d'assemblage comprenant une étape d'obtention F1 d'un connecteur 226 selon le procédé de fabrication d'un connecteur précédemment décrit, et une étape de plaquage et de fixation de la portion plane BP2+ de la barre omnibus principale positive BP+ et de la portion plane BP2- de la barre omnibus principale négative BP- contre respectivement les deuxièmes portions planes BA2+, BA2- des barres omnibus auxiliaires BA+, BA-.

En particulier cette étape de placage et de fixation de la portion plane BP2+ de la barre omnibus principale positive BP+ et de la portion plane BP2- de la barre omnibus principale négative BP- contre respectivement les deuxièmes portions BA2+, BA2- des barres omnibus auxiliaires BA+, BA- comprend une étape de fixation par vissage des deuxièmes portions BA2+, BA2- des barres omnibus auxiliaires BA+, BA- aux portions planes BP2+, BP2- des barres omnibus principales BP+, BP- selon une direction de vissage sensiblement perpendiculaire aux deuxièmes portions BA2+, BA2- des barres omnibus auxiliaire BA+, BA-.

## Revendications

1. Filtre de compatibilité électromagnétique (600), comportant :
- un premier conducteur (LD-) ;
- un deuxième conducteur (LD+) comportant une pince (P3A) se projetant selon un axe dit vertical (Y) dans un sens dit vers le haut (A3) ;
- un troisième conducteur (LD0) comportant :
• une première pince (P1B) et une deuxième pince (P2B) se projetant sur un même axe dit oblique mais dans des sens opposés (A1, A2), les première et deuxième pinces (P1B, P2B) étant situées plus hautes que la pince (P3A) du premier conducteur (LD+),
• une borne de connexion (606) située plus bas que les première et deuxième pinces (P1B, P2B), et
• un corps allongé (702) reliant la borne de connexion (606) aux première et deuxième pinces (P1B, P2B) ;
- une première capacité (C1) connectée entre le premier conducteur (LD-) et le troisième conducteur (LD0), la première capacité (C1) comportant une broche (C1B) se projetant selon un premier axe (D1B) sensiblement perpendiculaire à l'axe vertical (Y) et à l'axe oblique, cette broche (C1B) de la première capacité (C1) étant enserrée par la première pince (P1B) du troisième conducteur (LD0) ;
- une deuxième capacité (C2) connectée entre le deuxième conducteur (LD+) et le troisième conducteur (LD0), la deuxième capacité (C2) comportant une broche (C2B) se projetant selon un deuxième axe (D2B) sensiblement parallèle au premier axe (D1B), cette broche (C2B) de la deuxième capacité (C2) étant enserrée par la deuxième pince (P2B) du troisième conducteur (LD0) ; et
- une troisième capacité (C3) connectée entre le premier conducteur (LD+) et le deuxième conducteur (LD-), la troisième capacité (C3) comportant une broche (C3A) se projetant selon un troisième axe (D3A), sensiblement parallèle aux premier et deuxième axes (D1B, D2B), la broche (C3A) de la troisième capacité (C3) étant enserrée par la pince (P3A) du premier conducteur (LD+), la borne de connexion (606) du troisième conducteur (LD0) étant située plus bas, par rapport à l'axe vertical (Y), que cette broche (C3A) de la troisième capacité (C3) ;
**caractérisé en ce que** la broche (C1B) de la première capacité (C1) est située plus haut, par rapport à l'axe vertical (Y), que la broche (C2B) de la deuxième capacité (C2), de sorte que l'axe oblique et l'axe vertical (Y) fassent entre eux un angle inférieur à 80°, de préférence inférieur à 70°, par exemple de 65°.

2. Filtre de compatibilité électromagnétique (600) selon la revendication 1, dans lequel les capacités (C1, C2, C3) présentent des boîtiers respectifs de forme générale parallélépipédiques avec des faces supérieures perpendiculaires à l'axe vertical (Y), la face supérieure de la première capacité (C1) s'étendant plus haut que la face supérieure de la deuxième capacité (C2) et la face supérieure de la troisième capacité (C3) s'étendant au-dessous de la face supérieure de la deuxième capacité (C2).

3. Filtre de compatibilité électromagnétique (600) selon la revendication 1 ou 2, dans lequel la première capacité (C1) présente une autre broche (C1A) parallèle à la première broche (C1B), dans lequel la deuxième capacité (C2) présente une autre broche (C2A) parallèle à la première broche (C2B), un premier plan défini par les deux broches (C1A, C1B) de la première capacité (C1) et un deuxième plan défini par les deux broches (C2A, C2B) de la deuxième capacité (C2) étant sensiblement parallèles, le premier plan s'étendant au-dessus du deuxième plan.

4. Filtre de compatibilité électromagnétique (600) selon l'une quelconque des revendications 1 à 3, dans lequel le corps allongé (702) présente une portion d'extrémité droite (801) à partir de laquelle les pinces (P1B, P2B) du troisième conducteur (LD0) se projettent sensiblement perpendiculairement, cette portion d'extrémité droite (801) s'écartant horizontalement de la pince (P3A) du premier conducteur (LD+) en suivant cette portion d'extrémité droite (801) depuis les pinces (P1B, P2B) du troisième conducteur (LD0).

5. Procédé de fabrication d'un filtre de comptabilité électromagnétique (600) selon l'une quelconque des revendications 1 à 4, comportant :
- une obtention d'un filtre de compatibilité électromagnétique (600), comportant :
• un premier conducteur (LD-),
• un deuxième conducteur (LD+) comportant une pince (P3A) se projetant selon un axe dit vertical (Y) dans un sens dit vers le haut (A3),
• un troisième conducteur (LD0) comportant : une première pince (P1B) et une deuxième pince (P2B) se projetant sur un même axe dit oblique mais dans des sens opposés (A1, A2), les première et deuxième pinces (P1B, P2B) étant situées plus hautes que la pince (P3A) du premier conducteur (LD+), une borne de connexion (606) située plus bas que les première et deuxième pinces (P1B, P2B), et un corps allongé (702) reliant la borne de connexion (606) aux première et deuxième pinces (P1B, P2B),
• une première capacité (C1) connectée entre le premier conducteur (LD-) et le troisième conducteur (LD0), la première capacité (C1) comportant une broche (C1B) se projetant selon un premier axe (D1B) sensiblement perpendiculaire à l'axe vertical (Y) et à l'axe oblique,
• une deuxième capacité (C2) connectée entre le deuxième conducteur (LD+) et le troisième conducteur (LD0), la deuxième capacité (C2) comportant une broche (C2B) se projetant selon un deuxième axe (D2B) sensiblement parallèle au premier axe (D1B),
• une troisième capacité (C3) connectée entre le premier conducteur (LD+) et le deuxième conducteur (LD-), la troisième capacité (C3) comportant une broche (C3A) se projetant selon un troisième axe (D3A), parallèle aux premier et deuxième axes (D1B, D2B), la borne de connexion (606) du troisième conducteur (LD0) étant située plus bas, par rapport à l'axe vertical (Y), que cette broche (C3A) de la troisième capacité (C3),
• la broche (C1B) de la première capacité (C1) étant située plus haut, par rapport à l'axe vertical (Y), que la broche (C2B) de la deuxième capacité (C2), de sorte que l'axe oblique et l'axe vertical (Y) fassent entre eux un angle inférieur à 90°, de préférence inférieur à 70°, par exemple de 65° ; et
- pour la pince (P3A) du deuxième conducteur (LD+), un placement de deux éléments (802, 804) respectivement de chaque côté de la pince (P3A), l'un des éléments s'étendant entre la pince (P3A) et le corps allongé (702) du troisième conducteur (LD0) et une utilisation des éléments (802, 804) pour que la pince (P3A) enserre la broche (C3A) de la troisième capacité ; et
- pour chacune des première et deuxième pinces (P1B, P2B) du troisième conducteur (LD0), un placement de deux éléments (802, 804) respectivement de chaque côté de la pince (P1B, P2B) et une utilisation des éléments (802, 804) pour que la pince (P1B, P2B) enserre respectivement la broche (C1B) de la première capacité (C1) et la broche (C2B) de la deuxième capacité (C2).

6. Procédé selon la revendication 5, dans lequel l'utilisation des éléments (802, 804) comporte un rapprochement des éléments (802, 804) l'un de l'autre.

7. Procédé selon la revendication 5 ou 6, dans lequel l'utilisation des éléments (802, 804) comporte l'utilisation des éléments (802, 804) comme électrodes pour faire passer un courant au travers de la pince (P3A, P1B, P2B) et de la broche (C3A, C1B, C2B) associée pour les souder l'un à l'autre.

8. Convertisseur électrique continu-continu (114) comportant :
- un circuit électrique de conversion (218) conçu pour convertir une tension d'entrée (VIN) continue en une tension de sortie (VOUT) continue ;
- un connecteur d'entrée ou bien de sortie (226), comportant deux broches (B+, B-) plates, l'une (B+) positive et l'autre (B-) négative, conçues pour recevoir la tension d'entrée (VIN) ou bien pour fournir la tension de sortie (VOUT) ; et
- un filtre de compatibilité électromagnétique selon l'une quelconque des revendications 1 à 5, dans lequel les premier et deuxième conducteurs (LD+, LD-) sont respectivement connectées aux deux broches (B+, B-), et dans lequel le troisième connecteur (LD0) est connecté à une masse électrique.

9. Engin de mobilité comportant un filtre de compatibilité électromagnétique selon l'une quelconque des revendications 1 à 5 ou bien un convertisseur électrique continu-continu (114) selon la revendication 8.

## Patentansprüche

1. Elektromagnetischer Verträglichkeitsfilter (600), aufweisend:
- einen ersten Leiter (LD-);
- einen zweiten Leiter (LD+) mit einer Klemme (P3A), die sich entlang einer sogenannten vertikalen Achse (Y) in einer sogenannten Aufwärtsrichtung (A3) erstreckt;
- einen dritten Leiter (LDO) aufweisend:
- eine erste Klemme (P1B) und eine zweite Klemme (P2B), die sich entlang derselben sogenannten schrägen Achse, jedoch in entgegengesetzten Richtungen (A1, A2) erstrecken, wobei die erste und die zweite Klemme (P1B, P2B) höher angeordnet sind als die Klemme (P3A) des ersten Leiters (LD+),
- einen Anschluss (606), der tiefer angeordnet ist als die erste und die zweite Klemme (P1B, P2B), und
- einen länglichen Körper (702), der den Anschluss (606) mit der ersten und der zweiten Klemme (P1B, P2B) verbindet;
- einen ersten Kondensator (C1), der zwischen dem ersten Leiter (LD-) und dem dritten Leiter (LDO) verbunden ist, wobei der erste Kondensator (C1) einen Anschlussstift (C1B) aufweist, der sich entlang einer ersten Achse (D1B) erstreckt, die im Wesentlichen senkrecht zur vertikalen Achse (Y) und zur schrägen Achse ist, wobei dieser Anschlussstift (C18) des ersten Kondensators (C1) von der ersten Klemme (P1B) des dritten Leiters (LDO) umgriffen wird;
- einen zweiten Kondensator (C2), der zwischen dem zweiten Leiter (LD+) und dem dritten Leiter (LDO) verbunden ist, wobei der zweite Kondensator (C2) einen Anschlussstift (C2B) aufweist, der sich entlang einer zweiten Achse (D2B) erstreckt, die im Wesentlichen parallel zur ersten Achse (D1B) ist, wobei dieser Anschlussstift (C2B) des zweiten Kondensators (C2) von der zweiten Klemme (P2B) des dritten Leiters (LDO) umgriffen wird; und
- einen dritten Kondensator (C3), der zwischen dem ersten Leiter (LD+) und dem zweiten Leiter (LD-) verbunden ist, wobei der dritte Kondensator (C3) einen Anschlussstift (C3A) aufweist, der sich entlang einer dritten Achse (D3A) erstreckt, die im Wesentlichen parallel zur ersten und zur zweiten Achse (D1B, D2B) ist, wobei der Anschlussstift (C3A) des dritten Kondensators (C3) von der Klemme (P3A) des ersten Leiters (LD+) umgriffen wird, wobei der Anschluss (606) des dritten Leiters (LDO) bezüglich der vertikalen Achse (Y) tiefer angeordnet ist als dieser Anschlussstift (C3A) des dritten Kondensators (C3);
**dadurch gekennzeichnet, dass** der Anschlussstift (C18) des ersten Kondensators (C1) bezüglich der vertikalen Achse (Y) höher angeordnet ist als der Anschlussstift (C2B) des zweiten Kondensators (C2), sodass die schräge Achse und die vertikale Achse (Y) miteinander einen Winkel von weniger als 80°, vorzugsweise weniger als 70°, beispielsweise 65°, einschließen.

2. Elektromagnetischer Verträglichkeitsfilter (600) nach Anspruch 1, bei dem die Kondensatoren (C1, C2, C3) jeweilige Gehäuse von allgemein quaderförmiger Form mit zur vertikalen Achse (Y) senkrechten Oberseiten aufweisen, wobei sich die Oberseite des ersten Kondensators (C1) höher erstreckt als die Oberseite des zweiten Kondensators (C2) und sich die Oberseite des dritten Kondensators (C3) unterhalb der Oberseite des zweiten Kondensators (C2) erstreckt.

3. Elektromagnetischer Verträglichkeitsfilter (600) nach Anspruch 1 oder 2, bei dem der erste Kondensator (C1) einen weiteren Anschlussstift (C1A) parallel zum ersten Anschlussstift (C1B) aufweist, bei dem der zweite Kondensator (C2) einen weiteren Anschlussstift (C2A) parallel zum ersten Anschlussstift (C2B) aufweist, wobei eine erste Ebene, die durch die beiden Anschlussstifte (C1A, C1B) des ersten Kondensators (C1) definiert wird, und eine zweite Ebene, die durch die beiden Anschlussstifte (C2A, C2B) des zweiten Kondensators (C2) definiert wird, im Wesentlichen parallel sind, wobei sich die erste Ebene oberhalb der zweiten Ebene erstreckt.

4. Elektromagnetischer Verträglichkeitsfilter (600) nach einem der Ansprüche 1 bis 3, bei dem der längliche Körper (702) einen geraden Endabschnitt (801) aufweist, von dem aus sich die Klemmen (P1B, P2B) des dritten Leiters (LDO) im Wesentlichen senkrecht erstrecken, wobei sich dieser gerade Endabschnitt (801) horizontal von der Klemme (P3A) des ersten Leiters (LD+) entfernt, wenn man diesem geraden Endabschnitt (801) von den Klemmen (P1B, P2B) des dritten Leiters (LDO) aus folgt.

5. Verfahren zur Herstellung eines elektromagnetischen Verträglichkeitsfilters (600) nach einem der Ansprüche 1 bis 4, aufweisend:
- ein Bereitstellen eines elektromagnetischen Verträglichkeitsfilters (600), aufweisend:
- einen ersten Leiter (LD-),
- einen zweiten Leiter (LD+) mit einer Klemme (P3A), die sich entlang einer sogenannten vertikalen Achse (Y) in einer sogenannten Aufwärtsrichtung (A3) erstreckt,
- einen dritten Leiter (LDO) aufweisend: eine erste Klemme (P1B) und eine zweite Klemme (P2B), die sich entlang derselben sogenannten schrägen Achse, jedoch in entgegengesetzten Richtungen (A1, A2) erstrecken, wobei die erste und die zweite Klemme (P1B, P2B) höher angeordnet sind als die Klemme (P3A) des ersten Leiters (LD+), einen Anschluss (606), der tiefer angeordnet ist als die erste und die zweite Klemme (P1B, P2B), und einen länglichen Körper (702), der den Anschluss (606) mit der ersten und der zweiten Klemme (P1B, P2B) verbindet,
- einen ersten Kondensator (C1), der zwischen dem ersten Leiter (LD-) und dem dritten Leiter (LDO) verbunden ist, wobei der erste Kondensator (C1) einen Anschlussstift (C1B) aufweist, der sich entlang einer ersten Achse (D1B) erstreckt, die im Wesentlichen senkrecht zur vertikalen Achse (Y) und zur schrägen Achse ist,
- einen zweiten Kondensator (C2), der zwischen dem zweiten Leiter (LD+) und dem dritten Leiter (LDO) verbunden ist, wobei der zweite Kondensator (C2) einen Anschlussstift (C2B) aufweist, der sich entlang einer zweiten Achse (D2B) erstreckt, die im Wesentlichen parallel zur ersten Achse (D1B) ist,
- einen dritten Kondensator (C3), der zwischen dem ersten Leiter (LD+) und dem zweiten Leiter (LD-) verbunden ist, wobei der dritte Kondensator (C3) einen Anschlussstift (C3A) aufweist, der sich entlang einer dritten Achse (D3A) erstreckt, die parallel zur ersten und zur zweiten Achse (D1B, D2B) ist, wobei der Anschluss (606) des dritten Leiters (LDO) bezüglich der vertikalen Achse (Y) tiefer angeordnet ist als dieser Anschlussstift (C3A) des dritten Kondensators (C3),
- wobei der Anschlussstift (C1B) des ersten Kondensators (C1) bezüglich der vertikalen Achse (Y) höher angeordnet ist als der Anschlussstift (C2B) des zweiten Kondensators (C2), sodass die schräge Achse und die vertikale Achse (Y) miteinander einen Winkel von weniger als 90°, vorzugsweise weniger als 70°, beispielsweise 65°, einschließen; und
- für die Klemme (P3A) des zweiten Leiters (LD+), ein Platzieren von zwei Elementen (802, 804) jeweils auf beiden Seiten der Klemme (P3A), wobei sich eines der Elemente zwischen der Klemme (P3A) und dem länglichen Körper (702) des dritten Leiters (LDO) erstreckt, und ein Verwenden der Elemente (802, 804), damit die Klemme (P3A) den Anschlussstift (C3A) des dritten Kondensators umgreift; und
- für jede der ersten und zweiten Klemmen (P1B, P2B) des dritten Leiters (LD0), ein Platzieren von zwei Elementen (802, 804) jeweils auf beiden Seiten der Klemme (P1B, P2B) und ein Verwenden der Elemente (802, 804), damit die Klemme (P1B, P2B) jeweils den Anschlussstift (C1B) des ersten Kondensators (C1) und den Anschlussstift (C2B) des zweiten Kondensators (C2) umgreift.

6. Verfahren nach Anspruch 5, bei dem das Verwenden der Elemente (802, 804) ein Annähern der Elemente (802, 804) aneinander umfasst.

7. Verfahren nach Anspruch 5 oder 6, bei dem das Verwenden der Elemente (802, 804) das Verwenden der Elemente (802, 804) als Elektroden umfasst, um einen Strom durch die Klemme (P3A, P1B, P2B) und den zugehörigen Anschlussstift (C3A, C1B, C2B) fließen zu lassen, um diese miteinander zu verschweißen.

8. Elektrischer Gleichstrom-Gleichstrom-Wandler (114), aufweisend:
- einen elektrischen Wandlerschaltkreis (218), der dazu ausgelegt ist, eine kontinuierliche Eingangsspannung (VIN) in eine kontinuierliche Ausgangsspannung (VOUT) umzuwandeln;
- einen Eingangs- oder Ausgangsverbinder (226), aufweisend zwei flache Anschlussstifte (B+, B-), einen positiven (B+) und einen negativen (B-), die dazu ausgelegt sind, die Eingangsspannung (VIN) zu empfangen oder die Ausgangsspannung (VOUT) bereitzustellen; und
- einen elektromagnetischen Verträglichkeitsfilter nach einem der Ansprüche 1 bis 5, bei dem der erste und der zweite Leiter (LD+, LD-) jeweils mit den beiden Anschlussstiften (B+, B-) verbunden sind, und bei dem der dritte Verbinder (LDO) mit einer elektrischen Masse verbunden ist.

9. Mobilitätsfahrzeug, aufweisend einen elektromagnetischen Verträglichkeitsfilter nach einem der Ansprüche 1 bis 5 oder einen elektrischen Gleichstrom-Gleichstrom-Wandler (114) nach Anspruch 8.

## Claims

1. Electromagnetic compatibility filter (600), comprising:
- a first conductor (LD-);
- a second conductor (LD+) comprising a clamp (P3A) projecting along an axis referred to as vertical (Y) in a direction referred to as upward (A3);
- a third conductor (LDO) comprising:
- a first clamp (P1B) and a second clamp (P2B) projecting along the same axis referred to as oblique but in opposite directions (A1, A2), the first and second clamps (P1B, P2B) being located higher than the clamp (P3A) of the first conductor (LD+),
- a connection terminal (606) located lower than the first and second clamps (P1B, P2B), and
- an elongated body (702) connecting the connection terminal (606) to the first and second clamps (P1B, P2B);
- a first capacitor (C1) connected between the first conductor (LD-) and the third conductor (LDO), the first capacitor (C1) comprising a pin (C1B) projecting along a first axis (D1B) substantially perpendicular to the vertical axis (Y) and to the oblique axis, this pin (C1B) of the first capacitor (C1) being gripped by the first clamp (P1B) of the third conductor (LDO);
- a second capacitor (C2) connected between the second conductor (LD+) and the third conductor (LDO), the second capacitor (C2) comprising a pin (C2B) projecting along a second axis (D2B) substantially parallel to the first axis (D1B), this pin (C2B) of the second capacitor (C2) being gripped by the second clamp (P2B) of the third conductor (LDO); and
- a third capacitor (C3) connected between the first conductor (LD+) and the second conductor (LD-), the third capacitor (C3) comprising a pin (C3A) projecting along a third axis (D3A), substantially parallel to the first and second axes (D1B, D2B), the pin (C3A) of the third capacitor (C3) being gripped by the clamp (P3A) of the first conductor (LD+), the connection terminal (606) of the third conductor (LDO) being located lower, with respect to the vertical axis (Y), than this pin (C3A) of the third capacitor (C3);
**characterised in that** the pin (C1B) of the first capacitor (C1) is located higher, with respect to the vertical axis (Y), than the pin (C2B) of the second capacitor (C2), such that the oblique axis and the vertical axis (Y) form between them an angle of less than 80°, preferably less than 70°, for example 65°.

2. Electromagnetic compatibility filter (600) according to claim 1, wherein the capacitors (C1, C2, C3) have respective housings of generally parallelepiped shape with upper faces perpendicular to the vertical axis (Y), the upper face of the first capacitor (C1) extending higher than the upper face of the second capacitor (C2) and the upper face of the third capacitor (C3) extending below the upper face of the second capacitor (C2).

3. Electromagnetic compatibility filter (600) according to claim 1 or 2, wherein the first capacitor (C1) has another pin (C1A) parallel to the first pin (C18), wherein the second capacitor (C2) has another pin (C2A) parallel to the first pin (C2B), a first plane defined by the two pins (C1A, C1B) of the first capacitor (C1) and a second plane defined by the two pins (C2A, C2B) of the second capacitor (C2) being substantially parallel, the first plane extending above the second plane.

4. Electromagnetic compatibility filter (600) according to any one of claims 1 to 3, wherein the elongated body (702) has a straight end portion (801) from which the clamps (P1B, P2B) of the third conductor (LDO) project substantially perpendicularly, this straight end portion (801) moving horizontally away from the clamp (P3A) of the first conductor (LD+) when following this straight end portion (801) from the clamps (P1B, P2B) of the third conductor (LDO).

5. Method of manufacturing an electromagnetic compatibility filter (600) according to any one of claims 1 to 4, comprising:
- obtaining an electromagnetic compatibility filter (600), comprising:
- a first conductor (LD-),
- a second conductor (LD+) comprising a clamp (P3A) projecting along an axis referred to as vertical (Y) in a direction referred to as upward (A3),
- a third conductor (LDO) comprising: a first clamp (P1B) and a second clamp (P2B) projecting along the same axis referred to as oblique but in opposite directions (A1, A2), the first and second clamps (P1B, P2B) being located higher than the clamp (P3A) of the first conductor (LD+), a connection terminal (606) located lower than the first and second clamps (P1B, P2B), and an elongated body (702) connecting the connection terminal (606) to the first and second clamps (P1B, P2B),
- a first capacitor (C1) connected between the first conductor (LD-) and the third conductor (LDO), the first capacitor (C1) comprising a pin (C1B) projecting along a first axis (D1B) substantially perpendicular to the vertical axis (Y) and to the oblique axis,
- a second capacitor (C2) connected between the second conductor (LD+) and the third conductor (LDO), the second capacitor (C2) comprising a pin (C2B) projecting along a second axis (D2B) substantially parallel to the first axis (D1B),
- a third capacitor (C3) connected between the first conductor (LD+) and the second conductor (LD-), the third capacitor (C3) comprising a pin (C3A) projecting along a third axis (D3A), parallel to the first and second axes (D1B, D2B), the connection terminal (606) of the third conductor (LDO) being located lower, with respect to the vertical axis (Y), than this pin (C3A) of the third capacitor (C3),
- the pin (C1B) of the first capacitor (C1) being located higher, with respect to the vertical axis (Y), than the pin (C2B) of the second capacitor (C2), such that the oblique axis and the vertical axis (Y) form between them an angle of less than 90°, preferably less than 70°, for example 65°; and
- for the clamp (P3A) of the second conductor (LD+), placing two elements (802, 804) respectively on each side of the clamp (P3A), one of the elements extending between the clamp (P3A) and the elongated body (702) of the third conductor (LDO), and using the elements (802, 804) so that the clamp (P3A) grips the pin (C3A) of the third capacitor; and
- for each of the first and second clamps (P1B, P2B) of the third conductor (LDO), placing two elements (802, 804) respectively on each side of the clamp (P1B, P2B) and using the elements (802, 804) so that the clamp (P1B, P2B) grips respectively the pin (C1B) of the first capacitor (C1) and the pin (C2B) of the second capacitor (C2).

6. Method according to claim 5, wherein the use of the elements (802, 804) comprises bringing the elements (802, 804) closer to one another.

7. Method according to claim 5 or 6, wherein the use of the elements (802, 804) comprises using the elements (802, 804) as electrodes to pass a current through the clamp (P3A, P1B, P2B) and the associated pin (C3A, C1B, C2B) in order to weld them to one another.

8. DC-DC electric converter (114) comprising:
- an electric conversion circuit (218) designed to convert a continuous input voltage (VIN) into a continuous output voltage (VOUT);
- an input or output connector (226), comprising two flat pins (B+, B-), one (B+) positive and the other (B-) negative, designed to receive the input voltage (VIN) or to supply the output voltage (VOUT); and
- an electromagnetic compatibility filter according to any one of claims 1 to 5, wherein the first and second conductors (LD+, LD-) are respectively connected to the two pins (B+, B-), and wherein the third connector (LDO) is connected to an electrical ground.

9. Mobility vehicle comprising an electromagnetic compatibility filter according to any one of claims 1 to 5 or a DC-DC electric converter (114) according to claim 8.
